# EUROPEAN PATENT APPLICATION

(11) **EP 4 693 418 A1**
(43) Date of publication of application: **11.02.2026**
(21) Application number: 24779904.2
(22) Date of filing: 21.03.2024
(51) Int. Cl.: H01L 31/0749, B64U 10/25, B64U 10/30, B64U 50/31, H02S 10/40

(54) **PHOTOELECTRIC CONVERSION ELEMENT, PHOTOVOLTAIC MODULE, FLYING OBJECT AND METHOD FOR MANUFACTURING PHOTOELECTRIC CONVERSION ELEMENT**

(30) Priority: 31.03.2023 JP 2023059625
(71) Applicant: Idemitsu Kosan Co.,Ltd., Tokyo 100-8321 (JP)
(72) Inventor: KOMAKI, Hironori, Tokyo 100-8321 (JP); YAMAGUCHI, Koji, Tokyo 100-8321 (JP)
(74) Representative: Hoffmann Eitle
(86) International application number: PCT/JP2024/011172
(87) International publication number: WO 2024/203785

(57) **Abstract**

Provided is a photoelectric conversion element capable of maintaining the performance related to photoelectric conversion even under a low-temperature environment. The photoelectric conversion element (10) comprises: a photoelectric conversion layer (26) containing a selenide compound; a first electrode layer (22) containing Mo; and a first buffer layer (27) between the first electrode layer (22) and the photoelectric conversion layer (27). When y is a real number satisfying "0 ≤ y < 1", the first buffer layer (27) has a compound layer containing A(S_{y},Se_{1-y})₂. Element A is at least one of Nb and Ta.

## Description

### Technical Field

The present invention relates to a photoelectric conversion element, a photovoltaic module, a flying object, and a method for manufacturing a photoelectric conversion element.

### Background Art

Photoelectric conversion elements that convert light energy into electrical energy are known. As one of such photoelectric conversion elements, a photoelectric conversion element including a so-called CIS-based or CIGS-based photoelectric conversion layer (light absorption layer) is known.

The CIS-based or CIGS-based photoelectric conversion layer has a sulfide-based compound semiconductor. A photoelectric conversion layer containing a sulfide-based compound semiconductor is formed by forming a precursor film composed of Group I (such as Cu) and Group III (such as In and Ga) elements, and then performing heat treatment of the precursor film in a sulfur atmosphere (sulfurization of the precursor film).

Patent Literature 1 below discloses an electrode for a photoelectric conversion element. The electrode for a photoelectric conversion element includes a molybdenum layer and a sulfurization-resistant layer formed on the molybdenum layer. The sulfurization-resistant layer contains one or more elements selected from the group consisting of Nb, Ti, Ta, Au, V, Mn, and W.

Patent Literature 1 states that, when a molybdenum sulfide layer is formed in the electrode during sulfurization of the precursor film, the series resistance increases and causes a decrease in the conversion efficiency of the photoelectric conversion element. In Patent Literature 1, in order to prevent sulfurization of the molybdenum in the electrode layer, the sulfurization-resistant layer is provided between the photoelectric conversion layer and the electrode layer.

### Citation List

### Patent Literature

Patent Literature 1: JP 2014-049572 A

### Summary

The invention described in Patent Literature 1 is directed toward suppressing increase in sheet resistance associated with sulfurization of the molybdenum in the electrode layer. Referring to Example 1 of Patent Literature 1, experimental results are shown in which an electrode including a substrate, a molybdenum electrode layer and a sulfurized sulfurization-resistant layer was formed, and the sheet resistance of the electrode was measured.

However, in Patent Literature 1, no experiments were conducted on a photoelectric conversion element in which the photoelectric conversion layer is formed on the sulfurization-resistant layer. Therefore, Patent Literature 1 does not provide any suggestion regarding the performance of a photoelectric conversion element including a photoelectric conversion layer.

The inventor of the present application considered using a photoelectric conversion element under a low-temperature environment. When the photoelectric conversion element is used, for example, at a high altitude on the Earth, the photoelectric conversion element is placed under a low-temperature environment.

Therefore, a photoelectric conversion element capable of maintaining performance related to photoelectric conversion even under a low-temperature environment is desired.

In one aspect, a photoelectric conversion element comprises: a photoelectric conversion layer containing a selenide compound; a first electrode layer containing Mo; and a first buffer layer between the first electrode layer and the photoelectric conversion layer. When y is a real number satisfying "0 ≤ y < 1", the first buffer layer has a compound layer containing A(S_{y},Se_{1-y})₂. Element A is at least one of Nb and Ta.

In one aspect, a photovoltaic module comprises the photoelectric conversion element described above.

In one aspect, a flying object comprising the photovoltaic module described above.

In one aspect, a method for manufacturing a photoelectric conversion element, the method comprises: forming a layer containing Mo on a substrate; forming a layer containing element A on the layer containing Mo, the element A being at least one of Nb and Ta; forming a precursor film on the layer containing the element A; and a chalcogenization step of forming a photoelectric conversion layer containing a selenide compound by selenization of the precursor film or by selenization and sulfurization of the precursor film. The chalcogenization step is performed such that a compound layer containing A(S_{y},Se_{1-y})₂ is formed when y is a real number satisfying "0 ≤ y < 1".

### Brief Description of Drawings

Fig. 1 is a schematic plan view of a photoelectric conversion element according to a first embodiment.
Fig. 2 is a schematic cross-sectional view of the photoelectric conversion element taken along line 2A-2A of Fig. 1.
Fig. 3 is a schematic cross-sectional view of a photoelectric conversion element according to the second embodiment.
Fig. 4 is a schematic cross-sectional view of a photoelectric conversion element according to the third embodiment.
Fig. 5 is a diagram for describing one step in the method for manufacturing the photoelectric conversion element.
Fig. 6 is a graph showing the temperature dependence of each characteristic of the photoelectric conversion element in the example and the reference example.
Fig. 7 is a diagram showing the temperature dependence of the current-voltage characteristics of the photoelectric conversion element in Example 1.
Fig. 8 is a diagram showing the temperature dependence of the current-voltage characteristics of the photoelectric conversion element in the reference example.
Fig. 9 is a schematic plan view of the photovoltaic module including the photoelectric conversion element.
Fig. 10 is a schematic perspective view of a flying object including a photovoltaic module.

### Description of Embodiments

Hereinafter, embodiments will be described with reference to the drawings. In the following drawings, the same or similar parts are denoted by the same or similar reference numerals. However, it should be noted that the drawings are schematic, and ratios of dimensions and the like may be different from actual ones.

### [First Embodiment]

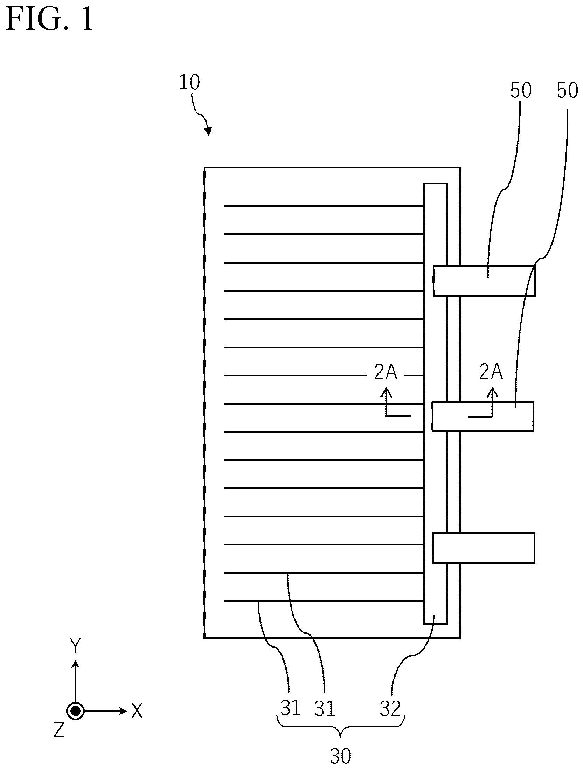

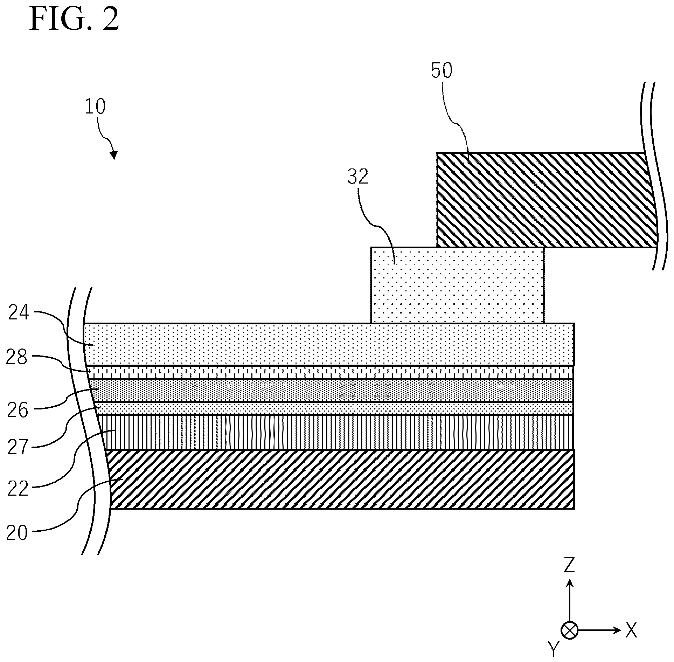

Fig. 1 is a schematic plan view of a photoelectric conversion element according to one embodiment. Fig. 2 is a schematic cross-sectional view of the photoelectric conversion element taken along line 2A-2A of Fig. 1.

A photoelectric conversion element 10 according to the present embodiment may be a thin-film type photoelectric conversion element. Preferably, the photoelectric conversion element 10 is a photovoltaic element that converts light energy into electrical energy.

The photoelectric conversion element 10 has a substrate 20 that serves as a base on which each film is formed. The substrate 20 may be formed of, for example, glass, ceramics, resin or metal. The substrate 20 may be a flexible substrate. The shape and dimensions of the substrate 20 are appropriately determined according to the size and the like of the photoelectric conversion element 10.

When a metal substrate is adopted as the substrate 20, the substrate 20 is formed of, for example, titanium (Ti), stainless steel (SUS), copper, aluminum, an alloy thereof, or the like. Alternatively, the substrate 20 may have a laminated structure in which a plurality of metal substrates are laminated, and for example, a stainless steel layer, a titanium layer, a molybdenum layer, or a molybdenum-sodium layer may be formed on the surface of the substrate.

The photoelectric conversion element 10 may include a first electrode layer 22, a first buffer layer 27 on the first electrode layer 22, a photoelectric conversion layer 26 on the first buffer layer 27, a second buffer layer 28 on the photoelectric conversion layer 26, and a second electrode layer 24 on the second buffer layer 28.

The photoelectric conversion layer 26 is provided between the first electrode layer 22 and the second electrode layer 24. The photoelectric conversion layer 26 is a layer that contributes to mutual conversion between light energy and electrical energy. In a photovoltaic element that converts light energy into electrical energy, the photoelectric conversion layer 26 may be referred to as a light absorption layer.

The first electrode layer 22 and the second electrode layer 24 are adjacent to the photoelectric conversion layer 26. In the present specification, the term "adjacent" shall mean not only that both layers are in direct contact, but also that both layers are in proximity via another layer.

The second electrode layer 24 may be formed of a transparent electrode layer. When the second electrode layer 24 is formed of a transparent electrode layer, light incident on the photoelectric conversion layer 26 or emitted from the photoelectric conversion layer 26 passes through the second electrode layer 24.

When the second electrode layer 24 is formed of a transparent electrode layer, the first electrode layer 22 may be formed of an opaque electrode layer or a transparent electrode layer. The first electrode layer 22 is a layer mainly containing molybdenum (Mo). The thickness of the first electrode layer 22 may be, for example, 50 nm to 1,500 nm.

As a preferable example, the second electrode layer 24 may be formed of an n-type semiconductor, more specifically, a material having n-type conductivity and relatively low resistance. The second electrode layer 24 can also function as an n-type semiconductor and a transparent electrode layer. The second electrode layer 24 includes, for example, a metal oxide to which a Group III element (B, Al, Ga, or In) is added as a dopant. Here, the description of "group" of an element in the present specification is based on the short-period form of the periodic table (hereinafter, the same shall apply).

Examples of the metal oxide constituting the second electrode layer 24 include ZnO and SnO₂. The second electrode layer 24 can be selected from, for example, indium tin oxide (In₂O₃:Sn), indium titanium oxide (In₂O₃:Ti), indium zinc oxide (In₂O₃:Zn). tin-zinc-doped indium oxide (In₂O₃:Sn,Zn), tungsten-doped indium oxide (In₂O₃:W), hydrogen-doped indium oxide (In₂O₃:H) indium gallium zinc oxide (InGaZnO₄), zinc tin oxide (ZnO:Sn), fluorine-doped tin oxide (SnO₂:F), gallium-doped zinc oxide (ZnO:Ga), boron-doped zinc oxide (ZnO:B), and aluminum-doped zinc oxide (ZnO:Al).

Although not particularly limited, the thickness of the second electrode layer 24 may be, for example, 500 nm to 2,500 nm.

The photoelectric conversion layer 26 may include, for example, a p-type semiconductor. In a specific example, the photoelectric conversion layer 26 may function as, for example, a polycrystalline or microcrystalline p-type compound semiconductor layer.

The photoelectric conversion layer 26 is a layer containing a selenide compound. The selenide compound may be a Group I-III-VI₂ compound semiconductor having a chalcopyrite structure. Here, the Group I element can be selected from copper (Cu), silver (Ag), and gold (Au). The Group III element can be selected from indium (In), gallium (Ga), and aluminum (Al). The photoelectric conversion layer 26 contains selenium (Se) as a Group VI element. The photoelectric conversion layer 26 may also contain, in addition to selenium (Se), sulfur (S) or tellurium (Te), or the like, as Group VI elements.

The composition of the selenide compound constituting the photoelectric conversion layer 26 is preferably a compound represented by Cu(In,Ga) (Sₓ,Se₁₋ₓ)₂. Here, the selenide compound according to this composition may contain at least one of indium and gallium. Here, the symbol x in the composition is a real number satisfying "0 ≤ x < 1" (hereinafter, the same shall apply.).

The first buffer layer 27 is provided between the first electrode layer 22 and the photoelectric conversion layer 26. The first buffer layer has a compound layer containing A(S_{y},Se_{1-y})₂ as a main component. Here, y is a real number satisfying "0 ≤ y < 1" (hereinafter, the same shall apply). The element A is at least one of Nb and Ta. Therefore, the compound layer constituting the first buffer layer 27 may include niobium selenide, niobium sulfo-selenide, tantalum selenide, and/or tantalum sulfo-selenide.

In the first buffer layer 27, the upper limit value of the thickness of the region in which the content proportion of the above-mentioned element A among the elements excluding S and Se is the highest may be, for example, less than 100 nm, preferably less than 50 nm, more preferably less than 30 nm, even more preferably less than 15 nm, and most preferably 12 nm or less.

In the first buffer layer 27, the lower limit value of the thickness of the region in which the content proportion of the above-mentioned element A among the elements excluding S and Se is the highest may be, for example, 1 nm or more, preferably 3 nm or more, and more preferably 5 nm or more.

In the first buffer layer 27, the thickness of the region in which the content proportion of the above-mentioned element A among the elements excluding S and Se is the highest may be within a range formed by any combination of the above-mentioned upper limit value and the lower limit value. The upper limit value and the lower limit value may be appropriately selected to optimize the characteristics of the photoelectric conversion element 10. From the viewpoint of suppressing peeling of the photoelectric conversion layer 26, it is preferable that the film thickness of the first buffer layer 27 be as small as possible.

As will be described later, the compound layer containing A(S_{y},Se_{1-y})₂ in the first buffer layer 27 is formed by forming a layer containing the element A on the Mo layer constituting the first electrode layer 22, forming a precursor film on the layer containing the element A, and then performing selenization or selenization and sulfurization. The thickness of the compound layer containing A(S_{y},Se_{1-y})₂ in the first buffer layer 27 may be increased by approximately 1.0 times to 3.0 times due to selenization or selenization and sulfurization. Therefore, in the first buffer layer 27, the thickness of the region in which the content proportion of the element A among the elements excluding S and Se is the highest is considered to be approximately 1.0 times to 3.0 times the thickness of the layer containing the element A formed on the Mo layer at the time of manufacturing.

The first buffer layer 27 may be made of a compound layer that substantially contains A (S_{y},Se_{1-y})₂. Alternatively, the first buffer layer 27 may include another layer different from the compound layer including A (S_{y},Se_{1-y})₂.

The second buffer layer 28 may be a semiconductor material having the same conductivity type as that of the second electrode layer 24, or may be a semiconductor material having a different conductivity type. The second buffer layer 28 may be formed of a material having higher electric resistance than the second electrode layer 24.

The second buffer layer 28 is formed on the photoelectric conversion layer 26. Although not particularly limited, the thickness of the second buffer layer 28 may be, for example, 10 nm to 100 nm.

The second buffer layer 28 can be selected from compounds containing zinc (Zn), cadmium (Cd), and indium (In). Examples of the compound containing zinc include ZnO, ZnS, Zn(OH)₂, or Zn(O,S) and Zn(O,S,OH) which are mixed crystals thereof, and further include ZnMgO and ZnSnO. Examples of the compound containing cadmium include CdS, CdO, and Cd(O,S) and Cd(O,S,OH) which are mixed crystals of CdS and CdO. Examples of the compound containing indium include In₂S₃ and In₂O₃, and In₂(O,S)₃ and In₂(O,S,OH)₃ which are mixed crystals of In₂S₃ and In₂O₃, and In₂O₃, In₂S₃, In(OH)ₓ, and the like can be used. The second buffer layer may have a laminated structure of these compounds.

The second buffer layer 28 has an effect of improving characteristics such as photoelectric conversion efficiency, but this may be omitted. When the second buffer layer 28 is omitted, the second electrode layer 24 is formed directly on the photoelectric conversion layer 26.

The photoelectric conversion element 10 may include a collecting electrode 30 on the second electrode layer 24. The collecting electrode 30 collects charge carriers from the second electrode layer 24, and is formed of a conductive material. The collecting electrode 30 may be in direct contact with the second electrode layer 24. From the viewpoint of improving the power generation efficiency, the area of the collecting electrode 30 is preferably as small as possible.

The collecting electrode 30 may have a plurality of substantially linear first parts 31 and a second part 32 connected to the first parts 31. The first part 31 may be referred to as a "finger". The second part 32 may be referred to as a "bus bar".

The first parts 31 are arranged at intervals. The plurality of linear first parts 31 are connected to the second part 32. The first part 31 has a function of guiding electricity generated in the photoelectric conversion layer 26 to the second part 32.

A plurality of the first parts 31 of the collecting electrode 30 may be provided to be arranged in the first direction (Y direction in the drawing). The plurality of linear first parts 31 may be connected to the same second part 32.

The second part 32 of the collecting electrode 30 may extend in the first direction (the Y direction in the drawing). The second part 32 may be connected to the first part 31 at the end portion of the first part 31. In this case, the plurality of first parts 31 may extend from the second part 32 along the second direction (X direction in the drawing).

The second part 32 of the collecting electrode 30 may extend substantially from the vicinity of one end to the vicinity of the other end of the photoelectric conversion element 10 in the first direction (Y direction in the drawing). The width (width in the X direction in the drawing) of the second part 32 of the collecting electrode 30 may be larger than the width (width in the Y direction in the drawing) of each of the first parts 31.

The collecting electrode 30 (the first part 31 and the second part 32) may be formed of a material having higher conductivity than the material constituting the second electrode layer 24. The material constituting the collecting electrode 30 can be selected from, for example, indium tin oxide (In₂O₃:Sn), indium titanium oxide (In₂O₃:Ti), indium zinc oxide (In₂O₃:Zn), tin-zinc-doped indium oxide (In₂O₃:Sn,Zn), tungsten-doped indium oxide (In₂O₃:W), hydrogen-doped indium oxide (In₂O₃:H), indium gallium zinc oxide (InGaZnO₄), zinc tin oxide (ZnO:Sn), fluorine-doped tin oxide (SnO₂:F), aluminum-doped zinc oxide (ZnO:Al), boron-doped zinc oxide (ZnO:B), gallium-doped zinc oxide (ZnO:Ga), at least one of Ni, Ti, Cr, Mo, Al, Ag, and Cu, or compounds containing one or more of these. The collecting electrode 30 may be made of an alloy or a laminate made of a combination of the above-described materials.

The photoelectric conversion element 10 may include a wiring 50 joined to the collecting electrode 30. The wiring 50 may be joined to the second part 32 of the collecting electrode 30. The wiring 50 may be, for example, an interconnector for electrically connecting to the outside of the photoelectric conversion element 10 and/or a connector for connecting with a bypass diode for electrically bypassing a cell that cannot perform photoelectric conversion.

In the above aspect, the photoelectric conversion element 10 includes the collecting electrode 30 and the wiring 50. However, the collecting electrode 30 and the wiring 50 are not essential components, and the photoelectric conversion element 10 may not include the collecting electrode 30 and the wiring 50.

For example, the photoelectric conversion element 10 may have an integrated structure in which a plurality of photoelectric conversion cells are integrated with each other. In this case, one or each of the plurality of photoelectric conversion cells may have the first electrode layer 22 and the first buffer layer 27 described above.

The photoelectric conversion element 10 may also be a so-called tandem-type photoelectric conversion element having a structure in which two photoelectric conversion cells are stacked on each other. In this case, one or both of the two photoelectric conversion cells may have the above-described first electrode layer 22 and first buffer layer 27.

### [Second Embodiment]

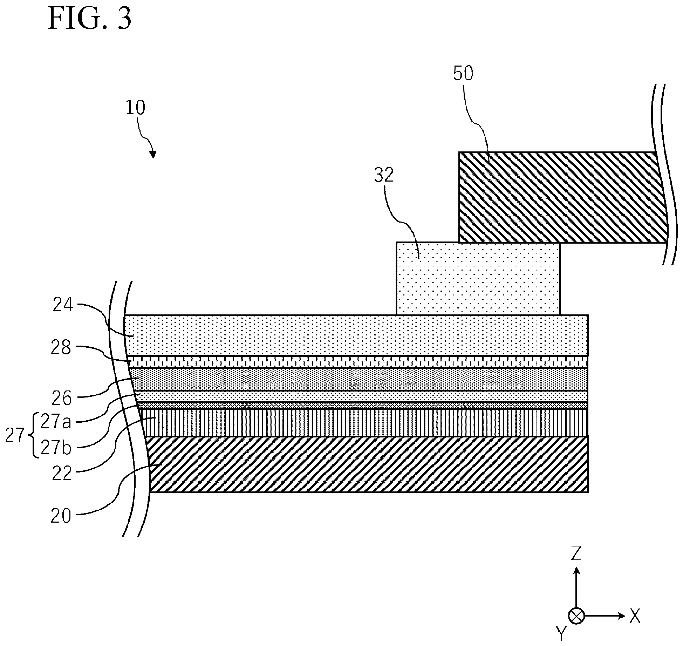

Hereinafter, a photoelectric conversion module according to a second embodiment will be described with reference to Fig. 3. Fig. 3 is a schematic cross-sectional view of a photoelectric conversion element according to the second embodiment. In the second embodiment, the same components as those in the first embodiment will be given the same reference numerals. It should be noted that the description of the same configuration as that of the first embodiment may be omitted.

The configuration of the photoelectric conversion module 10 in the second embodiment is the same as that in the first embodiment except for the structure of the first buffer layer 27. In the second embodiment, the first buffer layer 27 includes a compound layer 27a containing A(S_{y},Se_{1-y})₂ as a main component and a layer 27b containing Mo(S_{z},Se_{1-z})₂ to which the element A is added as a main component. The layer 27b containing Mo(S_{z},Se_{1-z})₂ to which the element A is added is provided between the compound layer 27a and the first electrode layer 22.

Here, y is a real number satisfying "0 ≤ y < 1" (hereinafter, the same shall apply). z is a real number satisfying "0 ≤ y < 1" (hereinafter, the same shall apply). The element A is, as in the first embodiment, at least one of Nb and Ta.

In the first buffer layer 27, the upper limit value of the thickness of the region (compound layer 27a) in which the content proportion of the above-mentioned element A among the elements excluding S and Se is the highest may be, for example, less than 100 nm, preferably less than 50 nm, more preferably less than 30 nm, even more preferably less than 15 nm, and most preferably 12 nm or less.

In the first buffer layer 27, the lower limit value of the thickness of the region (compound layer 27a) in which the content proportion of the above-mentioned element A among the elements excluding S and Se is the highest may be, for example, 1 nm or more, preferably 3 nm or more, and more preferably 5 nm or more.

In the first buffer layer 27, the thickness of the region in which the content proportion of the above-mentioned element A among the elements excluding S and Se is the highest may be within a range formed by any combination of the above-mentioned upper limit value and the lower limit value. The upper limit value and the lower limit value may be appropriately selected to optimize the characteristics of the photoelectric conversion element 10.

### [Third Embodiment]

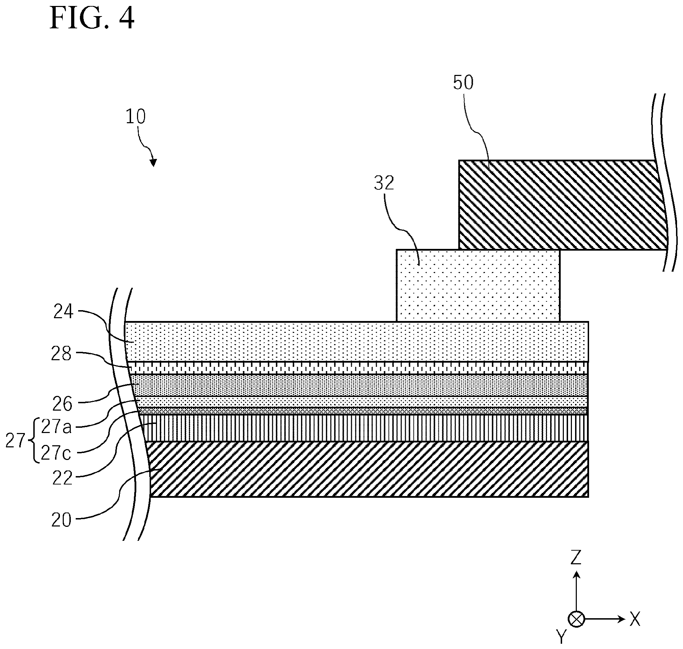

Hereinafter, a photoelectric conversion module according to a third embodiment will be described with reference to Fig. 4. Fig. 4 is a schematic cross-sectional view of a photoelectric conversion element according to the second embodiment. In the third embodiment, the same components as those in the first embodiment will be given the same reference numerals. It should be noted that the description of the same configuration as that of the first embodiment may be omitted.

The configuration of the photoelectric conversion module 10 in the third embodiment is the same as that in the first embodiment except for the structure of the first buffer layer 27. In the third embodiment, the first buffer layer 27 includes the compound layer 27a containing A(S_{y},Se_{1-y})₂ as a main component and the layer 27c containing the element A as a main component. The layer 27c containing the element A is provided between the compound layer 27a and the first electrode layer 22. Here, y is a real number satisfying "0 ≤ y < 1" (hereinafter, the same shall apply). The element A is, as in the first embodiment, at least one of Nb and Ta.

In the first buffer layer 27, the upper limit value of the thickness of the region (compound layer 27a) in which the content proportion of the above-mentioned element A among the elements excluding S and Se is the highest may be, for example, less than 100 nm, preferably less than 50 nm, more preferably less than 30 nm, even more preferably less than 15 nm, and most preferably 12 nm or less.

In the first buffer layer 27, the lower limit value of the thickness of the region (compound layer 27a) in which the content proportion of the above-mentioned element A among the elements excluding S and Se is the highest may be, for example, 1 nm or more, preferably 3 nm or more, and more preferably 5 nm or more.

In the first buffer layer 27, the thickness of the region in which the content proportion of the above-mentioned element A among the elements excluding S and Se is the highest may be within a range formed by any combination of the above-mentioned upper limit value and the lower limit value. The upper limit value and the lower limit value may be appropriately selected to optimize the characteristics of the photoelectric conversion element 10.

### [Method for Manufacturing Photoelectric Conversion Element]

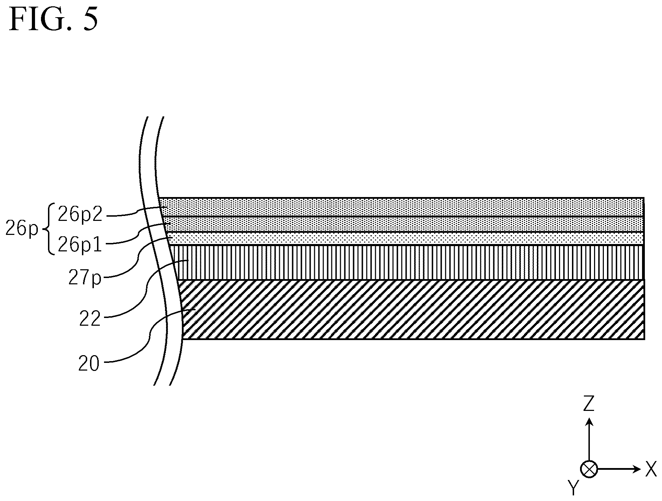

Next, a method for manufacturing the photoelectric conversion element according to the first embodiment, the second embodiment, and the third embodiment will be described with reference to Fig. 5. Fig. 5 is a diagram for describing one step in the method for manufacturing the photoelectric conversion element. Fig. 5 illustrates a state where a precursor film described later is formed.

First, a layer containing Mo is formed on the substrate 20. The layer containing Mo is formed on the surface of the substrate 20, for example, by a sputtering method. The sputtering method may be a direct current (DC) sputtering method or a radio frequency (RF) sputtering method. Instead of the sputtering method, a layer containing Mo may be formed by using a chemical vapor deposition (CVD) method, an atomic layer deposition (ALD) method, or the like. The layer containing Mo is formed as a material constituting the first electrode layer 22.

Next, a layer 27p containing at least one element A of Nb and Ta is formed on the layer containing Mo. The layer 27p containing the element A is formed by, for example, a sputtering method which is physical vapor deposition (PVD). The sputtering method may be a direct current (DC) sputtering method or a radio frequency (RF) sputtering method. The physical vapor deposition (PVD) may be, for example, an electron beam evaporation method, a pulsed laser method, or the like. Instead of the above-described method, the layer 27p containing the element A may be formed by using a chemical vapor deposition (CVD) method, an atomic layer deposition (ALD) method, or the like.

The layer 27p containing the element A is formed with a thickness of, for example, less than 50 nm, preferably less than 30 nm, more preferably less than 15 nm, and even more preferably 12 nm or less. Further, the layer 27p containing the element A is formed to have a thickness of, for example, 1 nm or more, preferably 3 nm or more, and more preferably 5 nm or more. The thickness of the layer 27p containing the element A may be in a range in which the upper limit value and the lower limit value are combined in any manner. The film thickness of the layer 27p containing the element A may be appropriately selected to optimize the characteristics of the manufactured photoelectric conversion element 10. From the viewpoint of suppressing peeling of the photoelectric conversion layer 26 after the chalcogenization step described later, the film thickness of the layer 27p containing the element A is preferably as small as possible.

Next, a precursor film 26p is formed on the layer 27p containing the element A. The precursor film 26p is a precursor for forming the photoelectric conversion layer 26.

The precursor film 26p may be a laminate including a film 26p1 containing a Group III element and a film 26p2 containing a Group I element. Specifically, after the film 26p1 containing the Group III element is formed on the layer 27p containing the element A, the film 26p2 containing the Group I element may be formed on the film 26p1 containing the Group III element.

The material constituting the film 26p2 containing the Group I element can be selected from, for example, Ag, Cu, Au, and the like. A material constituting the film 26p1 containing the Group III element can be selected from indium, gallium, aluminum, and the like. The precursor film 26p may additionally contain an alkali metal such as Li, Na, K, Rb, or Cs.

The precursor film 26p can be formed, for example, by a physical vapor deposition (PVD) method. Examples of the physical vapor deposition (PVD) method include a sputtering method and a vapor deposition method. The vapor deposition method is a method for forming a film by heating a vapor deposition source and using an atom or the like that has become a gas phase. Fig. 5 shows a state before the selenization step described later is started after the formation of the precursor film 26p is completed.

Next, the photoelectric conversion layer 26 containing a selenide compound is formed by selenization of the precursor film 26p or selenization and sulfurization of the precursor film 26p (chalcogenization step).

In the chalcogenization step, for example, first, selenization by a gas phase selenization method is performed. The selenization is performed by heating the precursor film 26p in an atmosphere of a selenium source gas (for example, hydrogen selenide or selenium vapor) containing selenium as a Group VI element source. Although not particularly limited, selenization is preferably performed, for example, at a temperature within a range of 300°C or more and 600°C or less in a heating furnace.

As a result, the precursor film 26p is converted into a selenide compound containing a Group I element, a Group III element, and selenium. The selenization may be performed by a method other than the gas phase selenization method. The selenization can also be performed by, for example, a solid-phase selenization method, a vapor deposition method, an ink application method, and/or an electrodeposition method.

Next, a selenide compound containing a Group I element, a Group III element, and selenium is sulfurized. The sulfurization is performed by heating the selenide compound in an atmosphere of a sulfur source gas (for example, hydrogen sulfide or sulfur vapor) containing sulfur. As a result, the selenide compound before sulfurization is converted into a selenide compound containing a Group I element, a Group III element, selenium, and sulfur. The sulfur source gas serves to substitute sulfur for selenium in a crystal composed of a Group I element, a Group III element, and selenium, for example, in a chalcopyrite crystal.

Although not particularly limited, sulfurization is preferably performed, for example, at a temperature within a range of 450°C or more and 650°C or less in a heating furnace.

In the above aspect, selenization and sulfurization of the precursor film 26p are performed. Alternatively, only selenization of the precursor film 26p may be performed without sulfurizing the precursor film 26p.

By selenization or by selenization and sulfurization, the precursor film 26p is converted into the photoelectric conversion layer 26 described above. By the selenization or by selenization and sulfurization, the compound layer containing A(S_{y},Se_{1-y})₂ is formed together with the formation of the selenide compound constituting the photoelectric conversion layer 26. Here, y is a real number satisfying "0 ≤ y < 1".

The compound layer containing A(S_{y},Se_{1-y})₂ is formed by selenization or by selenization and sulfurization of at least a part of the layer 27p containing the element A. Therefore, the element A contains at least one element of Nb and Ta. The compound layer containing A(S_{y},Se_{1-y})₂ is a constituent element of the first buffer layer 27 described in the first embodiment, the second embodiment, and the third embodiment. Here, when only selenization was performed, then y = 0 may satisfy. Meanwhile, when selenization and sulfurization are performed, y can be in a range satisfying "0 < y < 1".

In the chalcogenization step, substantially the entire layer 27p containing the element A is selenized or selenized and sulfurized, and the layer containing Mo for forming the first electrode layer 22 may not be substantially selenized or selenized and sulfurized. In this case, the first buffer layer 27 is constituted by a compound layer containing A(S_{y},Se_{1-y})₂. As a result, the first buffer layer 27 described in the first embodiment is obtained.

Alternatively, in the chalcogenization step, substantially the entire layer 27p containing the element A and a part of the surface side of the layer containing Mo for forming the first electrode layer 22 may be subjected to selenization or selenization and sulfurization. In this case, the first buffer layer 27 includes the compound layer 27a containing A(S_{y},Se_{1-y})₂ and the layer 27b containing Mo(S_{z},Se_{1-z})₂ to which the element A is added. Here, z is a real number satisfying "0 ≤ z < 1". Here, the layer 27b containing Mo(S_{z},Se_{1-z})₂ to which the element A is added is formed by selenization or selenization and sulfurization of a part of the surface side of the layer containing Mo and by doping with the element A in the upper layer thereof. Therefore, the layer 27b containing Mo(S_{z},Se_{1-z})₂ to which the element A is added is positioned between the compound layer 27a containing A(S_{y} Se_{1-y})₂ and the first electrode layer 22. In this manner, the first buffer layer 27 described in the second embodiment is obtained.

Alternatively, in the chalcogenization step, a part of the surface side of the layer 27p containing the element A may be subjected to selenization or selenization and sulfurization, and a part of the back side of the layer 27p containing the element A may be left substantially un-selenized or un-selenized and un-sulfurized. In this case, the first buffer layer 27 will include the compound layer 27a containing A(S_{y},Se_{1-y})₂ and a layer 27c containing the element A. The layer 27c containing the element A is positioned between the compound layer 27a containing A(S_{y},Se_{1-y})₂ and the first electrode layer 22. In this manner, the first buffer layer 27 described in the third embodiment is obtained.

Next, the second buffer layer 28 is formed on the photoelectric conversion layer 26 formed in the chalcogenization step, if necessary. The second buffer layer 28 can be formed by a method such as a chemical bath deposition (CBD) method, a sputtering method, a CVD method, or an ALD method. The material constituting the second buffer layer is as described above. The second buffer layer 28 may not be formed if unnecessary.

Next, the second electrode layer 24 is formed on the photoelectric conversion layer 26 or the second buffer layer 28. The second electrode layer 24 is formed by a method such as a sputtering method, a CVD method, or an ALD method. The material constituting the second electrode layer 24 is as described above.

Next, the collecting electrode 30 (the first part 31 and the second part 32) may be formed, and the wiring 50 may be formed as necessary. Through the above process, the photoelectric conversion elements described in the first embodiment, the second embodiment, and the third embodiment can be obtained.

Hereinafter, as a reference example, a case where the layer 27p containing at least one element A of Nb and Ta is not formed on the layer containing Mo in the process of manufacturing the photoelectric conversion element will be described. In this case, the precursor film 26p is directly formed on the layer containing Mo. In the reference example, during the step of selenization or selenization and sulfurization of the precursor film 26p, a part of the surface side of the layer containing Mo is selenized or selenized and sulfurized. Therefore, the first buffer layer 27 is formed substantially of Mo(S_{y},Se_{1-y})₂. That is, the photoelectric conversion layer 26 is in contact with Mo(S_{y},Se_{1-y})₂ serving as the first buffer layer 27.

Hereinafter, although it is estimated, an image of a band structure of an interface between the photoelectric conversion layer 26 and the first buffer layer 27 will be described for the photoelectric conversion element 10 according to the first embodiment, the second embodiment, and the third embodiment and the photoelectric conversion element according to the reference example. In the first embodiment, the second embodiment, and the third embodiment, there is an interface between the CIGS-based photoelectric conversion layer 26 and the A(S_{y},Se_{1-y})₂ layer (A = Nb or Ta).

A(S_{y},Se_{1-y})₂ is expected to be a metallic layer. Then, the A(S_{y},Se_{1-y})₂ layer is considered to become a metal-semiconductor junction including an ohmic junction by being joined to a photoelectric conversion layer (p-type semiconductor) containing a selenide compound. Therefore, it is presumed that the characteristics of carrier transfer under a low-temperature environment can be maintained.

Next, as the reference example described above, a case where the first buffer layer consist of a Mo(S_{y},Se_{1-y})₂ layer will be considered. Mo(S_{y},Se_{1-y})₂ is known as a semiconductor, and by joining with the photoelectric conversion layer (p-type semiconductor) containing a selenide compound, a band structure having a Schottky barrier is formed. Therefore, it is presumed that the carrier transfer characteristics are deteriorated by the Schottky barrier at a low temperature.

From the above examination, it is presumed that the photoelectric conversion element 10 according to the first embodiment, the second embodiment, and the third embodiment can maintain the performance related to photoelectric conversion even under a low-temperature environment as compared with the reference example described above.

### [Example 1]

Next, a photoelectric conversion element according to Example 1 will be described. In the photoelectric conversion element according to Example 1, the first electrode layer 22, the first buffer layer 27, the photoelectric conversion layer 26, the second buffer layer 28, and the second electrode layer 24 are laminated in this order on the MoNa layer on the titanium substrate. The first electrode layer 22 is formed of molybdenum. The first buffer layer 27 includes a compound layer made of Nb(S_{y},Se_{1-y})_{2.} The first buffer layer 27 is assumed to include the compound layer 27a containing Nb(S_{y},Se_{1-y})₂ as a main component and the layer 27b containing Mo(S₂,Se_{1-z})₂ to which Nb is added as a main component (the embodiment described in the second embodiment). The photoelectric conversion layer 26 is a Cu(In,Ga) (Sₓ,Se₁₋ₓ)₂ layer. The second buffer layer 28 is formed of CdS. The second electrode layer 24 is formed of In₂O₃.

At the time of manufacturing the photoelectric conversion element, an Mo layer as the first electrode layer 22 was formed on the MoNa layer on the titanium substrate, an Nb layer was formed on the Mo layer, and a predetermined precursor film (Cu(In,Ga) film) was formed on the Nb layer. The film thickness of the formed Nb layer was 9 nm.

Then, the precursor film and the Nb layer were selenized and sulfurized as described above to form the first buffer layer 27 and the photoelectric conversion layer 26. Next, the second buffer layer 28 and the second electrode layer 24 were formed in this order on the photoelectric conversion layer 26.

### [Reference Example]

The photoelectric conversion element according to the reference example was manufactured in the same manner as in Example 1 except that the Nb layer was not formed. Therefore, as described above, in the reference example, the Mo(S_{y},Se_{1-y})₂ layer is formed as the first buffer layer 27 under the photoelectric conversion layer 26 at the time of selenization and sulfurization of the precursor film.

### [Measurement of Characteristics of Photoelectric Conversion Element]

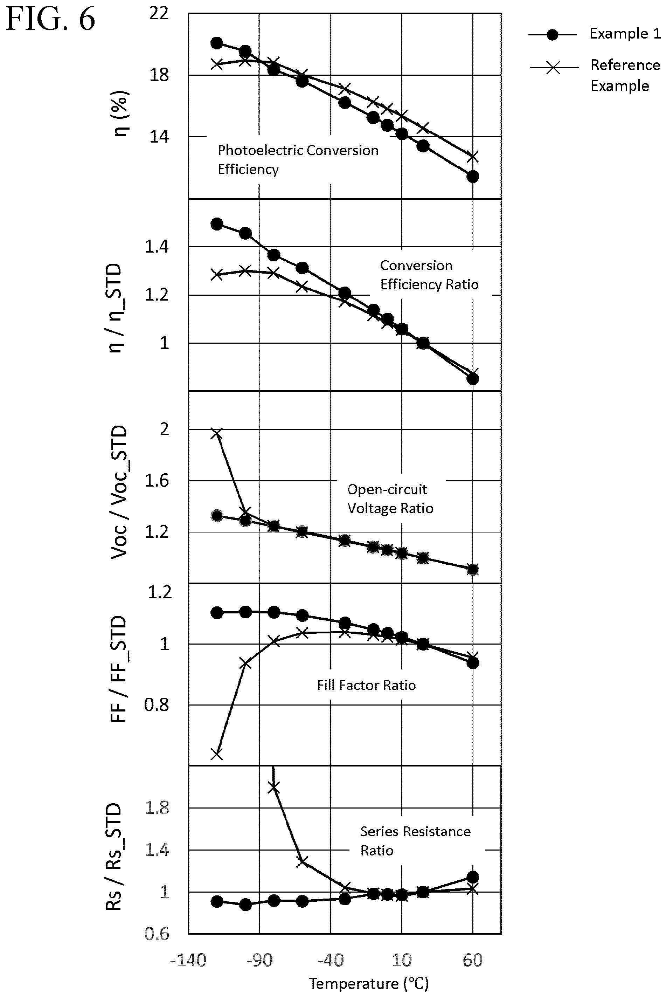

For the photoelectric conversion elements according to Example 1 and the reference example, the temperature dependence of the photoelectric conversion efficiency (η), the photoelectric conversion efficiency ratio (η/η__{STD}), the open-circuit voltage ratio (Voc/Voc__{STD}), the fill factor ratio (FF/FF__{STD}) and the series resistance ratio (Rs/Rs _{_STD}) was measured. These measurements were performed under the condition that the photoelectric conversion element was irradiated with 1,000 W/m² of sunlight or simulated sunlight using a solar simulator. Fig. 6 is a graph showing the temperature dependence of each characteristic of the photoelectric conversion element in Example 1 and the reference example.

In Fig. 6, η__{STD}, Voc__{STD}, FF__{STD}, and Rs__{STD} respectively refer to the photoelectric conversion efficiency, open-circuit voltage, fill factor, and series resistance of the photoelectric conversion element at a temperature of 25°C. Accordingly, the photoelectric conversion efficiency ratio (η/η__{STD}), open-circuit voltage ratio (Voc/Voc__{STD}), fill factor ratio (FF/FF__{STD}) and series resistance ratio (Rs/Rs __{STD}) each correspond to the value obtained by dividing the photoelectric conversion efficiency, open-circuit voltage, fill factor and series resistance at each temperature by the photoelectric conversion efficiency, open-circuit voltage, fill factor and series resistance at 25°C.

The photoelectric conversion efficiency (η) in Example 1 increases as the temperature decreases. The photoelectric conversion efficiency in the reference example increases as the temperature decreases in the range of 25°C to -80°C. However, in the reference example, in the range of -30°C to -80°C, the rate of increase in the photoelectric conversion efficiency accompanying the temperature decrease is low (refer to also the graph of the photoelectric conversion efficiency ratio). Furthermore, in the reference example, the photoelectric conversion efficiency does not increase at a temperature of -80°C or lower. As a result, the photoelectric conversion efficiency in Example 1 is higher than the photoelectric conversion efficiency in the reference example at a temperature of -90°C or lower.

The fill factor ratio (FF/FF__{STD}) in Example 1 increases as the temperature decreases. Meanwhile, the fill factor ratio in the reference example decreases as the temperature decreases below approximately -30°C to -60°C. The fill factor at a temperature of -90°C in the reference example is considered to be lower than the fill factor at 25°C.

The series resistance ratio (Rs/Rs __{STD}) in Example 1 slightly decreases as the temperature decreases. Meanwhile, the series resistance ratio in the reference example rapidly increases at a temperature of -30°C to - 40°C or lower as the temperature decreases. The series resistance ratio in Example 1 is significantly smaller than the series resistance ratio in the reference example at a temperature of -30°C to -40°C or less. Therefore, it is considered that the photoelectric conversion element according to Example 1 can be more significant from the viewpoint of photoelectric conversion than the photoelectric conversion element according to the reference example at a temperature lower than -30°C to -40°C.

From the results shown in Fig. 6, it is considered that the photoelectric conversion element according to Example 1 may become significant from the viewpoint of photoelectric conversion compared to the photoelectric conversion element according to the reference example at a temperature lower than -30°C to -40°C.

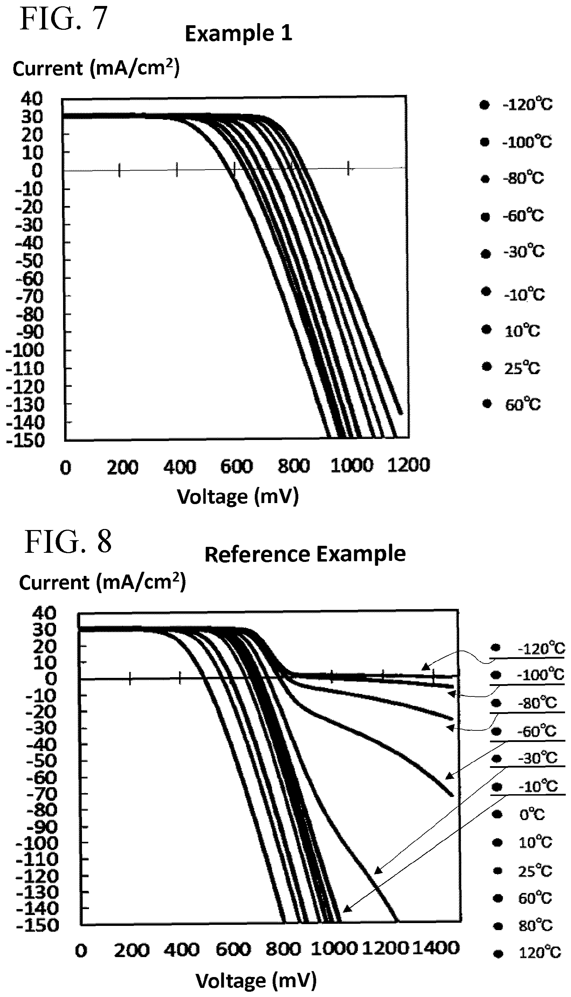

For the photoelectric conversion elements according to Example 1 and the reference example, the temperature dependence of the current-voltage characteristics was measured. The measurement was performed under conditions in which sunlight or simulated sunlight at 1,000 W/m² was irradiated onto the photoelectric conversion element using a solar simulator. Fig. 7 is a diagram showing the temperature dependence of the current-voltage characteristics of the photoelectric conversion element in Example 1. Fig. 8 is a diagram showing the temperature dependence of the current-voltage characteristics of the photoelectric conversion element in the reference example. In Fig. 7, a plurality of lines in the graph indicate current-voltage characteristics at 60°C, 25°C, 10°C, -10°C, -30°C, -60°C, -80°C, -100°C, and -120°C in order from the left. In Fig. 8, a plurality of lines in the graph represent the current-voltage characteristics at 120°C, 80°C, 60°C, 25°C, 10°C, 0°C, -10°C, -30°C, -60°C, -80°C, - 100°C, and -120°C in order from the left.

Referring to Fig. 7, in the photoelectric conversion element according to Example 1, the current decreases with an upward convex curve as the voltage increases at any temperature in the range of 60°C to -120°C. As described above, the photoelectric conversion element according to Example 1 exhibits normal current-voltage characteristics at a temperature in the range of 60°C to -120°C.

Referring to Fig. 8, in the photoelectric conversion element according to the reference example, the current decreases with an upward convex curve as the voltage increases at any temperature in the range of 120°C to - 10°C. However, in the photoelectric conversion element according to the reference example, one or two inflection points are observed in the current-voltage curve with the increase in voltage at a temperature in the range of -30°C to -120°C. As described above, the photoelectric conversion element according to the reference example exhibits abnormal current-voltage characteristics at a temperature in the range of -30°C to -120°C.

From the measurement results of the current-voltage characteristics, it is found that the photoelectric conversion element according to Example 1 may be able to maintain the performance related to photoelectric conversion even under a low-temperature environment.

### [Photovoltaic Module]

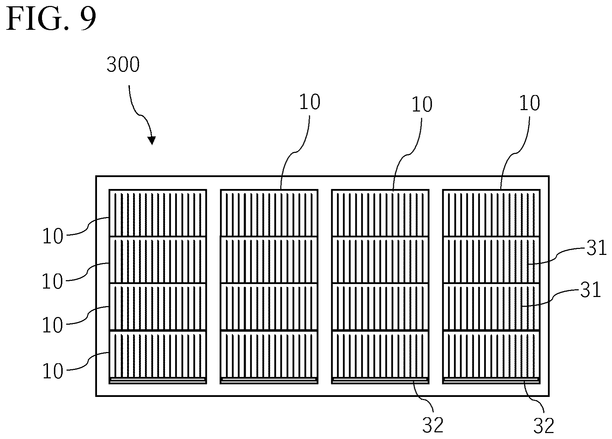

Next, a photovoltaic module including a photoelectric conversion element will be described. Fig. 9 is a schematic plan view of the photovoltaic module including the photoelectric conversion element. A photovoltaic module 300 may include one or more photoelectric conversion elements 10. Note that Fig. 9 shows the photoelectric conversion module 300 including the plurality of photoelectric conversion elements 10. The one or more photoelectric conversion elements 10 may be sealed with, for example, a sealing material.

When the photoelectric conversion module 300 includes the plurality of photoelectric conversion elements 10, the plurality of photoelectric conversion elements 10 may be arranged in at least one direction, and preferably may be arranged in a lattice pattern. In this case, the plurality of photoelectric conversion elements 10 may be electrically connected to each other in series and/or in parallel.

In the example shown in Fig. 9, the photoelectric conversion elements 10 are arranged to partially overlap each other. Among the photoelectric conversion elements 10 arranged in one direction, adjacent photoelectric conversion elements 10 partially overlap each other. Specifically, as shown in Fig. 9, a certain photoelectric conversion element 10 may be disposed to cover the second part 32 of the collecting electrode 30 of the photoelectric conversion element 10 adjacent thereto. Instead of the aspect shown in Fig. 9, the photoelectric conversion elements 10 adjacent to each other may be arranged at intervals. The wiring 50 described above may electrically connect the photoelectric conversion elements 10 adjacent to each other.

### [Flying Object]

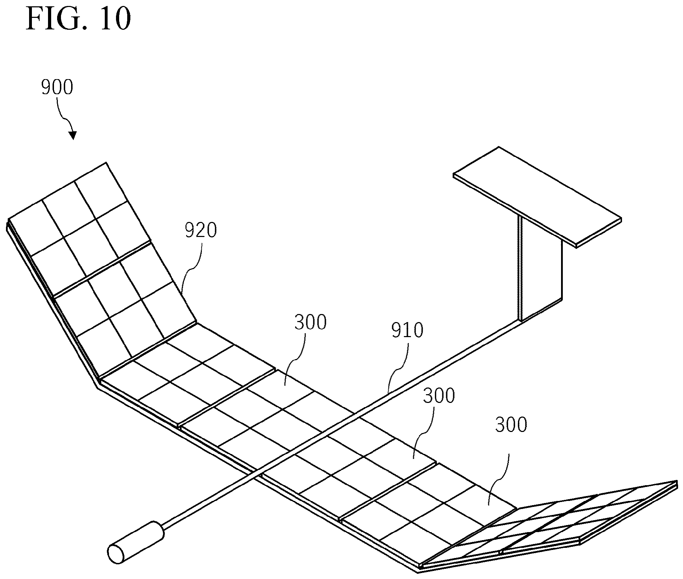

Next, a flying object provided with a photovoltaic module will be described. Fig. 10 is a schematic perspective view of a flying object including a photovoltaic module. A flying object 900 may have a base portion 910 and a wing portion 920.

The wing portion 920 may include the photovoltaic module 300 described above. Preferably, the wing portion 920 includes the plurality of photovoltaic modules 300. Since the flying object 900 is exposed to a low-temperature environment during operation, it is desirable to use the photovoltaic module 300 including the photoelectric conversion element 10 described above. The flight altitude at the time of operation of the flying object 900 is not particularly limited. The flying object 900 may fly, for example, in the stratosphere. In this case, the flying object 900 may be exposed to a temperature environment of - 70°C to -100°C.

In Fig. 10, the flying object 900 includes the wing portion 920. Alternatively, the flying object 900 may not include the wing portion 920. The flying object 900 may have a shape such as an airship or a balloon, for example. Even in this case, the flying object 900 may be provided with one or a plurality of photovoltaic modules 300. Here, the photovoltaic module 300 may generate power by sunlight, or may generate power by light other than sunlight.

As described above, the contents of the present invention have been disclosed through the embodiments, but it should not be understood that the description and the drawings constituting a part of the disclosure limit the present invention. From this disclosure, various alternative embodiments, examples, and operational techniques will become apparent to those skilled in the art. Therefore, the technical scope of the present invention is defined only by the matters specifying the invention according to the claims appropriate from the above description.

This application claims priority based on Japanese Patent Application No. 2023-059625 filed on March 31, 2023, the entire contents of which are incorporated herein by reference.

## Claims

1. A photoelectric conversion element comprising:
a photoelectric conversion layer containing a selenide compound;
a first electrode layer containing Mo; and
a first buffer layer between the first electrode layer and the photoelectric conversion layer, wherein,
when y is a real number satisfying "0 ≤ y < 1", the first buffer layer has a compound layer containing A(S_{y},Se_{1-y})₂, and
element A is at least one of Nb and Ta.

2. The photoelectric conversion element according to claim 1, wherein
in the first buffer layer, a thickness of a region in which a content proportion of the element A among the elements excluding S and Se is the highest is less than 100 nm.

3. The photoelectric conversion element according to claim 1 or 2, wherein
in the first buffer layer, a thickness of a region in which a content proportion of the element A among the elements excluding S and Se is the highest is 1 nm or more and 12 nm or less.

4. The photoelectric conversion element according to any one of claims 1 to 3, wherein the selenide compound is a Group I-III-VI₂ compound semiconductor.

5. The photoelectric conversion element according to any one of claims 1 to 4, wherein the first buffer layer consists of the compound layer that substantially contains A (S_{y},Se_{1-y})₂.

6. The photoelectric conversion element according to any one of claims 1 to 4, wherein
when z is a real number satisfying "0 ≤ z < 1", the first buffer layer has a layer containing Mo(S_{z},Se_{1-z})₂ to which the element A is added, between the compound layer and the first electrode layer.

7. The photoelectric conversion element according to any one of claims 1 to 4, wherein the first buffer layer has a layer containing the element A between the compound layer and the first electrode layer.

8. A photovoltaic module comprising the photoelectric conversion element according to any one of claims 1 to 7.

9. A flying object comprising the photovoltaic module according to claim 8.

10. A method for manufacturing a photoelectric conversion element, the method comprising:
forming a layer containing Mo on a substrate;
forming a layer containing element A on the layer containing Mo, the element A being at least one of Nb and Ta;
forming a precursor film on the layer containing the element A; and
a chalcogenization step of forming a photoelectric conversion layer containing a selenide compound by selenization of the precursor film or by selenization and sulfurization of the precursor film, wherein
the chalcogenization step is performed such that a compound layer containing A(S_{y},Se_{1-y})₂ is formed when y is a real number satisfying "0 ≤ y < 1".

11. The method for manufacturing a photoelectric conversion element according to claim 10, wherein the layer containing the element A is formed with a thickness of less than 50 nm.

12. The method for manufacturing a photoelectric conversion element according to claim 10 or 11, wherein the layer containing the element A is formed with a thickness of 1 nm or more and 12 nm or less.

13. The method for manufacturing a photoelectric conversion element according to any one of claims 10 to 12, wherein the precursor film is a laminate including a film containing a Group III element and a film containing a Group I element.

14. The method for manufacturing a photoelectric conversion element according to any one of claims 10 to 13, wherein the chalcogenization step includes substantially selenizing or selenizing and sulfurizing the entire layer containing the element A, without substantially selenizing or selenizing and sulfurizing the layer containing Mo.

15. The method for manufacturing a photoelectric conversion element according to any one of claims 10 to 13, wherein the chalcogenization step includes selenizing or selenizing and sulfurizing substantially the entire layer containing the element A and a part of a surface of the layer containing Mo.

16. The method for manufacturing a photoelectric conversion element according to any one of claims 10 to 13, wherein the chalcogenization step includes selenizing or selenizing and sulfurizing a part of a surface of the layer containing the element A.
